# EUROPEAN PATENT APPLICATION

(11) **EP 4 354 486 A1**
(43) Date of publication of application: **17.04.2024**
(21) Application number: 22201402.9
(22) Date of filing: 13.10.2022
(51) Int. Cl.: H01J 37/24, H01J 37/244

(54) **ELECTRON-OPTICAL ELEMENT**

(71) Applicant: ASML Netherlands B.V., 5500 AH Veldhoven (NL)
(72) Inventor: KONING, Johan, Joost, 5500 AH Veldhoven (NL); DEL TIN, Laura, 5500 AH Veldhoven (NL)
(74) Representative: ASML Netherlands B.V.

(57) **Abstract**

A charged particle-optical element for a charged particle-optical module configured to direct charged particles along at least one beam path, the charged particle-optical element comprising: a substrate comprising at least one aperture for passage therethrough of the at least one beam path; at least one electronic component so as to provide a component surface of the substrate; and an electrical connector electrically connected to the at least one electronic component and extending through the substrate; wherein the substrate comprises a thicker portion and a thinner portion that is thinner than the thicker portion, and the electrical connector extends through the thinner portion.

## Description

### FIELD

The embodiments provided herein generally relate to a charged particle-optical element, a charged particle-optical part, a charged particle-optical module, a charged particle-optical device, a charged particle-optical apparatus and a method for providing an electrical connection though a substrate of a charged particle-optical element.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern assessment systems for example pattern inspection tools with a charged particle beam have been used to assess objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection apparatus has a single beam and may be referred to as a Single Beam SEM. There have been attempts to introduce a multi-electron beam inspection in an apparatus (or a 'multi-beam tool') which may be referred to as Multi Beam SEM (MBSEM).

Another application for an electron-optical device (or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and optionally magnetic fields).

Electrical signals (e.g. power and/or communication) may be transferred to and/or from electronic components of the electron-optical device, for example to operate on the beams of charged particles and/or process signals of collected electrons. Space constraints within the electron-optical device can make it difficult to provide the electrical connection.

### SUMMARY

The present invention provides a suitable architecture to enable improved electrical connection for an electronic component.

According to a first aspect of the invention, there is provided a charged particle-optical element for a charged particle-optical module configured to direct charged particles along at least one beam path, the charged particle-optical element comprising: a substrate comprising at least one aperture for passage therethrough of the at least one beam path; at least one electronic component so as to provide a component surface of the substrate; and an electrical connector electrically connected to the at least one electronic component and extending through the substrate; wherein the substrate comprises a thicker portion and a thinner portion that is thinner than the thicker portion, and the electrical connector extends through the thinner portion.

According to a second aspect of the invention, there is provided a method for providing an electrical connection though a substrate of a charged particle-optical element for a charged particle-optical module configured to direct charged particles along at least one beam path extending through at least one aperture through the substrate for passage therethrough of the at least one beam path, the method comprising: extending an electrical connector through a portion of a substrate that has a component surface provided by at least one electronic component, such that the electrical connector is electrically connected to the at least one electronic component; wherein the substrate comprises at least one aperture for passage therethrough of the at least one beam path, the substrate comprises a thicker portion and a thinner portion that is thinner than the thicker portion in a direction parallel to the at least one beam path, and the electrical connector extends through the thinner portion.

According to a third aspect of the invention, there is provided a method for providing an electrical connection though a substrate of a charged particle-optical element for a charged particle-optical module configured to direct charged particles along at least one beam path extending through at one aperture through the substrate for passage therethrough of the at least one beam path, the method comprising: extending an electrical connector through a portion of a substrate that has a component surface provided by at least one electronic component, such that the electrical connector is electrically connected to the at least one electronic component; and defining at least one aperture through the substrate for passage therethrough of the at least one beam path, wherein the substrate comprises a thicker portion and a thinner portion that is thinner than the thicker portion in a direction parallel to the at least one beam path, and the electrical connector extends through the thinner portion.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam assessment apparatus.
Figure 2 is a schematic diagram illustrating an exemplary multi-beam electron-optical device that is part of the exemplary electron beam assessment apparatus of Figure 1.
Figure 3 is a schematic diagram of an exemplary electron-optical device comprising a collimator element array and a scan-deflector array that is part of the exemplary electron beam assessment apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam assessment apparatus of Figure 1.
Figure 6 is a schematic diagram of an exemplary electron-optical module that may be part of the electron-optical devices of Figures 3, 4 and 5.
Figure 7 is a schematic diagram of an exemplary electron-optical element.
Figure 8 is a schematic diagram of an exemplary electron-optical element.
Figure 9 is a schematic diagram of an exemplary electron-optical element.
Figure 10 is a schematic plan view of an exemplary electron-optical element.
Figure 11 is a schematic plan view of an exemplary electron-optical element.
Figures 12-15 are schematic views of different stages of an exemplary method of making the electron-optical element of Figure 8.
Figures 16-18 are schematic views of different stages of an exemplary method of making the electron-optical element of Figure 8.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### DETAILED DESCRIPTION

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by assessment systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of electron-optical apparatus embodying these scanning electron microscope features may have a single beam. For higher throughput such as for assessment, some designs of apparatus use multiple focused beams, i.e. a multibeam, of primary electrons. The component beams of the multi-beam may be referred to as sub-beams or beamlets. A multi-beam may scan different parts of a target simultaneously. A multi-beam assessment apparatus may therefore assess a target much quicker, e.g. by moving the target at a higher speed, than a single-beam assessment apparatus.

In a multi-beam assessment apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the signal particles (e.g. secondary electrons) from the target when they are detected, for example the shape and size of the spot formed by the sub-beam on the target will be affected. Such aberrations therefore degrade the quality of resulting images that are created during assessment.

An implementation of a known multi-beam assessment apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

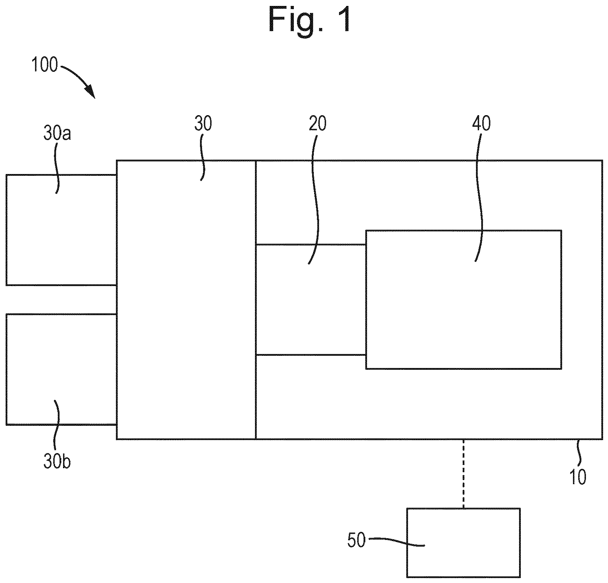

Reference is now made to Figure 1, which is a schematic diagram illustrating an exemplary electron beam assessment apparatus 100, or inspection apparatus. The assessment apparatus 100 of Fig. 1 includes a vacuum chamber 10, a load lock chamber 20, an electron-optical apparatus, an equipment front end module (EFEM) 30 and a controller 50. The electron-optical device 40 may be within the vacuum chamber 10. The electron-optical apparatus may comprise an electron-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be assessed (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be assessed. An electron-optical device 40 may comprise either a single beam or a multi-beam electron-optical apparatus.

The controller 50 is electronically connected to the electron-optical device 40. The controller 50 may be a processor (such as a computer) configured to control the charged particle beam assessment apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam assessment apparatus or it may be distributed over at least two of the component elements. While the present disclosure provides examples of main chamber 10 housing an electron beam assessment apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

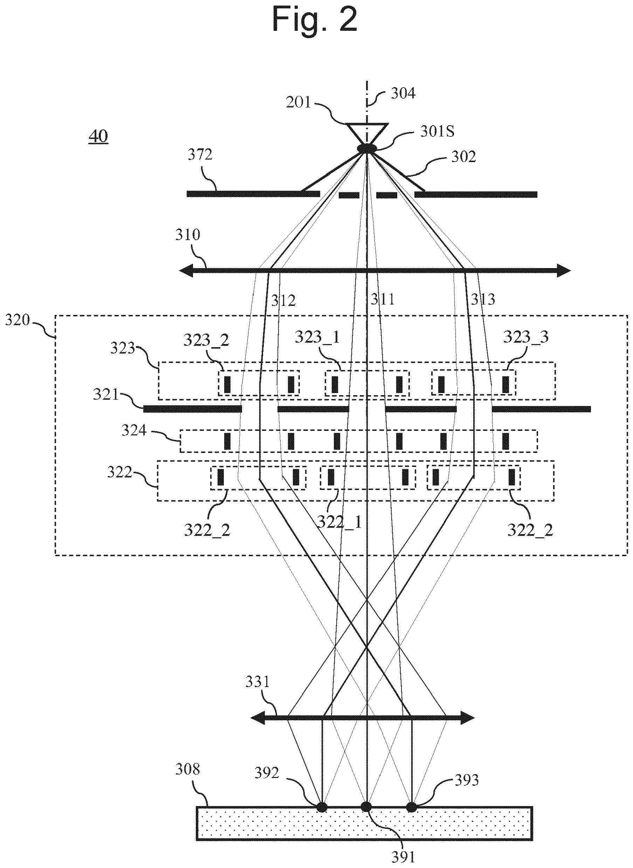

Reference is now made to Figure 2, which is a schematic diagram of an exemplary multi-beam electron-optical device 40 of an assessment apparatus, e.g. the assessment apparatus 100 of Figure 1. In an alternative embodiment the assessment apparatus 100 is a single-beam assessment apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. (In a single beam assessment apparatus may have the same features as a multibeam assessment apparatus except electron-optical components with an array apertures 372, 320 may have a single aperture. The source converter 320 may be replaced with a number of electron-optical components along the beam path.) The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate assessment resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system upbeam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of the beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical device 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be downbeam of the source converter 320. The beam separator may be, for example, a Wien filter comprising an electrostatic dipole field and a magnetic dipole field. The beam separator may be upbeam of the objective lens 331. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such Wien filter, a secondary device and/or a secondary projection apparatus may be provided in a single beam assessment apparatus. Additionally and/or alternatively a detection device may be present downbeam of the objective lens, for example facing the sample during operation. In an alternative arrangement a detector device is position along the path of the charged particle beam towards the sample. In such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electro-static plates may be arranged in series of two or more adjoining plates along the path of the charged particle beam.

In an embodiment the assessment apparatus 100 comprises a single source.

Any element or collection of elements may be replaceable or field replaceable within the electron-optical device. The one or more electron-optical components in the electron-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

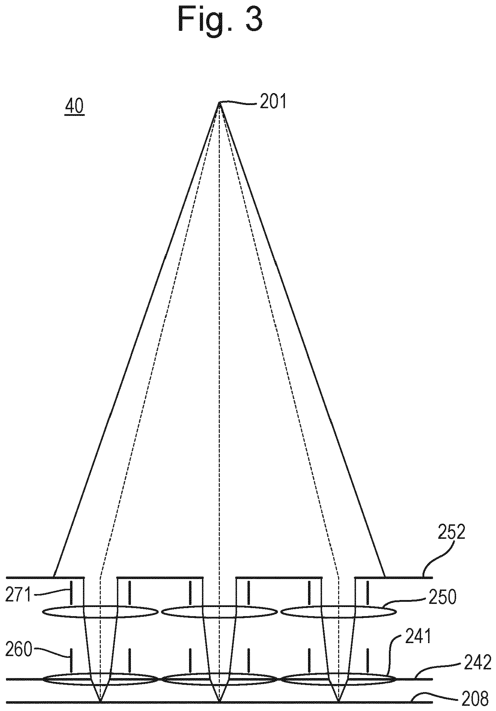

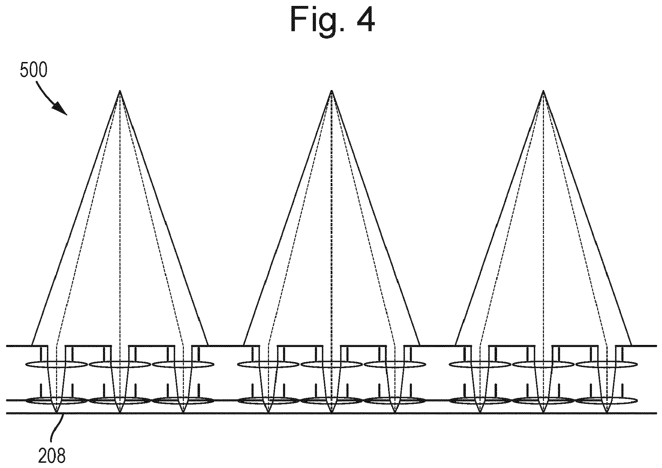

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided upbeam from the objective lenses. The condenser lenses focus each of the sub-beams to an intermediate focus upbeam of the objective lenses. In some embodiments, collimators are provided upbeam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image. The condenser lenses, objective lenses and/or detector may be formed as MEMS or CMOS devices.

Figure 3 is a schematic diagram of another design of an exemplary electron-optical device 40. The electron-optical device 40 may comprise a source 201 and one or more electron-optical assemblies. Alternatively, the electron-optical apparatus that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or upbeam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided downbeam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path downbeam of the source 201. In another arrangement, the collimator may take the form, wholly or partially, of a macro-collimator. Such a macro-collimator may be upbeam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned upbeam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens. Although the control lens array 241 may be indistinct from and part of the objective lens array 250, in this description the control lens array 250 is considered to be distinct and separate from the objective lens array 241.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used upbeam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is downbeam from at least one electrode (optionally from all electrodes) of the control lens array 250. In some embodiments, the beam shaping limiter 242 is downbeam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. The apertures of the beam shaping limiter 242 may have a smaller diameter than the apertures of at least one of the objective lens array 241, the control lens array 250, the detector array 240 and the upper beam limiter array 252. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. Note, the most downbeam electrode of the control lens array 250 may be the most upbeam electrode of the objective lens array 241. That is the control lens array 250 and the objective lens array 241 may share an electrode. The shared electrode provides different lensing effects for each lens, each lensing effect with respect one its two opposing surfaces (i.e. upbeam surface and downbeam surface). The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the electron-optical device facing the sample 208, e.g. the bottom surface of the electron-optical device. Alternative the detector array be upbeam of the bottom surface or example in or upbeam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample. Each electron-optical device may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical devices in the array 500 may be arranged adjacent to each other so as to project the respective multi-beams onto adjacent regions of the sample 208.

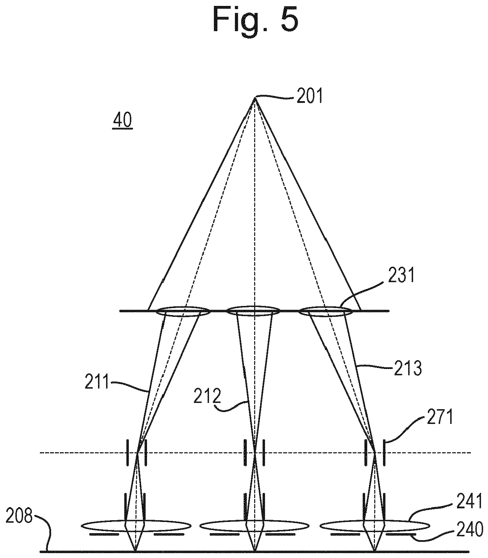

Any number of electron-optical devices may be used in the array 500. Preferably, the number of electron-optical devices is in the range of from two (2), desirably nine (9) to one hundred (100) even two hundred (200). In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array 500 may be configured in any of the ways described herein when referring to a single electron-optical device, for example as described above, especially with respect to the embodiment shown and described in reference to Figure 5. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3. Each of the electron-optical devices in this example thus comprise both a scan-deflector array 260 and a collimator element array 271. As mentioned above, the scan-deflector array 260 and collimator element array 271 are particularly well suited to incorporation into an electron-optical device array 500 because of their spatial compactness, which facilitates positioning of the electron-optical devices close to each other. This arrangement of electron-optical device may be preferred over other arrangements that use a magnetic lens as collimator. Magnetic lenses may be challenging to incorporate into an electron-optical device intended for use in a multi-device arrangement (e.g. multi-column arrangement) for example because of magnetic interference between columns.

An alternative design of multi-beam electron-optical device may have the same features as described with respect to Figure 3 expect as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multibeam device with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

In an embodiment of the arrangement shown in and described with reference to Figure 5, the detector may be located in similar locations in the electron-optical device 40 as described with reference to and as shown in the electron-optical device of Figure 3. The detector 240 may be integrated into the objective lens array 241 and the control lens array 250 (when present as it is not depicted in Figure 5). The detector may have more than one detector at different positions along the paths of the sub-beams of the multibeam, for example each array associated with a different electron-optical element, such as an electrode of the objective lens array and/or the control lens array. The objective lens array 241 and associated electron-optical elements such as the control lens array 250 may be comprised in assembly which may be a monolithic assembly which may be referred to as an electron-optical assembly or an electron-optical module 55. In an embodiment a detector 240 is associated with, or even integrated into, a planar element of the electron-optical module 55. For example, the detector 240 may be on the bottom surface of an electron-optical module 55 comprising objective lenses 241. The detector 240 may be provided with an electric connection 60 as described elsewhere in this document. In a variation, the detector has a detector array positioned upbeam of the objective lens array (optionally and the control lens array 250) for example upbeam of the electron-optical module 55. Between the electron-optical module 55 and the detector array may be a Wien filter array that directs the charged particles beams in a downbeam direction towards the sample and directs signal particles from the sample to the detector array.

An electron-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus. A further alternative design of multi-beam apparatus comprises multiple single beam devices. The single beams generated for the purposes of the invention herein described may be similar or equivalent to a multi-beam generated by a single device. Each device may have an associated detector. Such a multi-device apparatus may be arranged in an array of devices of three, four, nine, nineteen, fifty, one hundred or even two hundred devices each generating a single beam or beamlet (if of a single beam device) or a plurality of beams (if of multibeam devices). In this further alternative design the array of devices may have a common vacuum system, each device have a separate vacuum system or groups of devices are assigned different vacuum systems.

The electron-optical device 40 may be a component of an assessment apparatus (e.g. for inspection, metrology, metro-inspection or any other type of assessment) or part of an e-beam lithography apparatus or other type of charged particle induced sample patterning apparatus. The multi-beam charged particle apparatus may be used in a number of different applications that include electron microscopy in general, not just scanning electron microscopy, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, for example of the arrangement shown and described with reference to Figure 2, unless explicitly mentioned. The electron-optical axis 304 may be the same as, or different from, a mechanical axis of the electron-optical device 40. In context of the arrangement shown and described with respect to Figures 2 to 5, the electron-optical axis may correspond to the path of the central beam of the multibeam, for example beam 212. The beams of the multibeam are substantially parallel to each other (for example along the electron-optical axis 304) between collimation (e.g. the location of the collimator array 271 which correspond to a plane of intermediate foci (for example as shown in Figure 5) or an upper beam limiter 252) and the surface of the sample 208.

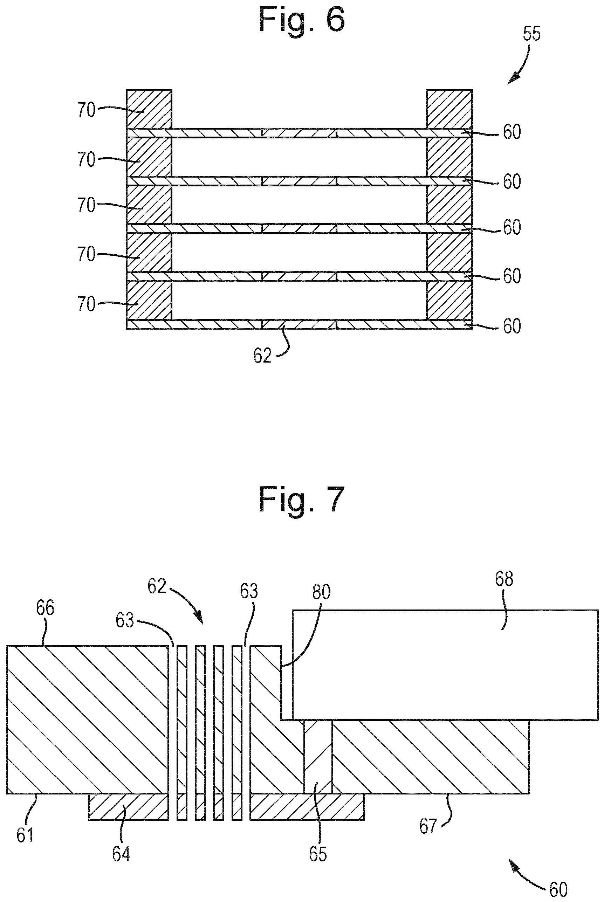

The electron-optical device 40 may comprise an electron-optical module 55 as shown in Figure 6 for manipulating electron beamlets. For example, the electron-optical module 55 may comprise one or more of (in a non-limited list): the objective lens array 241, and/or the condenser lens array 231 and/or the collimator element array 271 and/or an individual beam corrector and/or a deflector and/or a Wien filter array. In particular, the objective lens 331 and/or the condenser lens 310 and/or the control lens 250 may comprise the electron-optical module 55.

The electron-optical module 55 is configured to provide a potential difference between two or more plates (or substrates). An electrostatic field is generated between the plates, which act as electrodes. The electrostatic field results in an attraction force between the two plates. The attraction force may be increased with increasing potential difference.

Figure 6 schematically depicts an electron-optical module 55. The electron-optical module 55 is configured to direct electrons along at least one beam path towards a sample location. In the orientation shown in Figure 6, the at least one beam path extends vertically from top to bottom through the middle of the electron-optical module 55. There may be one beam path corresponding to one electron beam. Alternatively, there may be a plurality of beam paths corresponding to a plurality of electron sub-beams of a multi-beam.

As shown in Figure 6, in an embodiment the electron-optical module 55 comprises a plurality of planar elements arranged across the beam path. In an embodiment one or more of the planar elements is an electron-optical element 60. The electron-optical element 60 is configured to operate on the one or more electron beams. As shown in Figure 6, in an embodiment all of the planar elements are electron-optical elements 60. Alternatively, one or more of the planar elements may be a planar element other than an electron-optical element. For example, one or more of the planar elements may be an element that is not required to have a voltage applied to it in order for it to perform its function, or the planar element is required to have a voltage applied to it so there is substantially zero potential difference between the element and an adjoining element along the beam path. One example is a planar element that is a beam limiting aperture array comprising apertures dimensioned so as to shape the electron beams. For example, the apertures may allow electron beams of a particular shape to pass through, while blocking other electrons from transmitting through the beam limiting aperture array. As a further alternative, a planar element configured to shape the electron beams may also have a potential difference with respect to an upbeam and/or downbeam planar element such that the electromagnetic field affects the electron beams in addition to the beam shaping function.

As shown in Figure 6, in an embodiment the electron-optical module 55 comprises one or more spacers 70. The spacers 70 are configured to mechanically support the planar elements. As shown in Figure 6, in an embodiment a spacer 70 is configured to mechanically separate planar elements such as electron-optical elements 60 from each other. In an embodiment the spacers 70 are configured to electrically isolate planar elements such as electron-optical elements 60 from each other. However, it is not essential for the spacers 70 to provide electrical isolation. For example, it may be that two adjoining electron-optical elements 60 are arranged to be operated at the same voltage (i.e. having no potential difference between them), in which case electrical isolation may not be required. In an embodiment one or more pairs of adjoining planar elements are directly adjoined to each other, i.e. without an intermediate spacer 70. The spacers 70 are optional features.

The electron beams are configured to pass through the beam area 62 of the electron-optical module 55. As shown in Figure 6, the beam area 62 may be in a central portion of the electron-optical module 55. The beam area 62 is located generally centrally when viewed in a direction parallel to the at least one beam path. The beam area 62 is located centrally when viewed in a direction orthogonal to the plane of the planar elements.

In an embodiment the electron-optical module 55 is comprised in an electron-optical device 40, for example an electron-optical device 40 shown in Figure 2, Figure 3 or Figure 5. In an embodiment the electron-optical module 55 is field replaceable. The electron-optical module 55 may be removed from and/or inserted into the electron-optical device 40, without requiring any substantial dismantling of other parts of the electron-optical device 40. That is the electron-optical module 55 may be removable from and/or insertable into the electron-optical device 40.

In an embodiment the electron-optical module 55 comprises an objective lens assembly comprising the objective lens array 241. The electron-optical module 55 may further comprise a control lens array 250, a detector 240 and/or a deflector array. In an alternative embodiment, the electron-optical module 55 may be a condenser lens assembly. The electron-optical module 55 may comprise a condenser lens array 231. The electron-optical module 55 may further comprise one or more of a deflector array, a beam limiting aperture array, for example.

Figure 7 is a schematic view of an electron-optical element 60. Figure 7 is a schematic cross-sectional side view of the electron-optical element 60. The aspect ratio used in Figure 7 is selected so as to make some features of the electron-optical element 60 clearer.

The electron-optical element 60 is for an electron-optical module 55 such as the electron-optical module 55 shown in Figure 6. As shown in Figure 7, in an embodiment the electron-optical element 60 comprises a substrate 61. The substrate 61 may be a plate. The substrate 61 may be substantially planar. In an embodiment the substrate 61 comprises a semiconductor material. In an embodiment the substrate 61 comprises silicon.

As shown in Figure 7, in an embodiment the substrate 61 comprises at least one aperture 63. As shown in Figure 7, the apertures 63 extend through the substrate 61. Each aperture 63 is for the passage therethrough of at least one beam path. For example, Figure 7 shows a plurality of apertures 63. Each aperture 63 may allow one electron beam or a group of electron beams to pass through it. Figure 7 schematically shows five apertures 63. The number of apertures 63 may be much greater than five. As shown in Figure 7, the apertures 63 are provided in the beam area 62 of the electron-optical element 60. In an alternative embodiment there may be only one aperture 63. For example the electron-optical device 40 which comprises the electron-optical element 60 may be configured to direct a single electron beam towards a sample location. Alternatively, the single aperture 63 may be for the passage therethrough of a plurality of sub-beams of a multi-beam (or beam grid). The electron-optical element 60 having the single aperture 63 may be a macro element configured to operate on all of the sub-beams for example of the multi-beam.

As shown in Figure 7, in an embodiment the electron-optical element 60 comprises at least one electronic component 64. The at least one electronic component 64 may be referred to as active electronics. The electronic component may be configured to operate at a voltage applied to it during use of the electron-optical element 60. The electronic component 64 may be configured to operate on one or more electron beams passing through the beam area 62. Additionally or alternatively, at least one electronic component 64 may be configured to detect signal electrons from the sample location.

As shown in Figure 7, in an embodiment the at least one electronic component 64 provides a component surface of the substrate 61. In the arrangement shown in Figure 7, the electronic component 64 provides the downbeam surface of the substrate 61. The substrate 61 may comprise two major surfaces. One of the major surfaces is the upbeam major surface at an upbeam end of the substrate 61. This is the top surface of the substrate in the orientation shown in Figure 7. The other of the major surfaces is the downbeam major surface. This is the lower surface of the substrate 61 in the orientation shown in Figure 7. The major surfaces of the substrate 61 are substantially planar. The major surfaces extend across the beam paths. The apertures 63 pass through the major surfaces of the substrate 61. The component surface provided by the at least one electronic component 64 is a major surface of the substrate 61. In the example shown in Figure 7, the component surface is at the downbeam major surface of the substrate 61. The downbeam major surface of the substrate 61 comprises the component surface. The component surface forms part (but not all) of the downbeam major surface. In an alternative embodiment, the component surface may be at the upbeam major surface of the substrate 61.

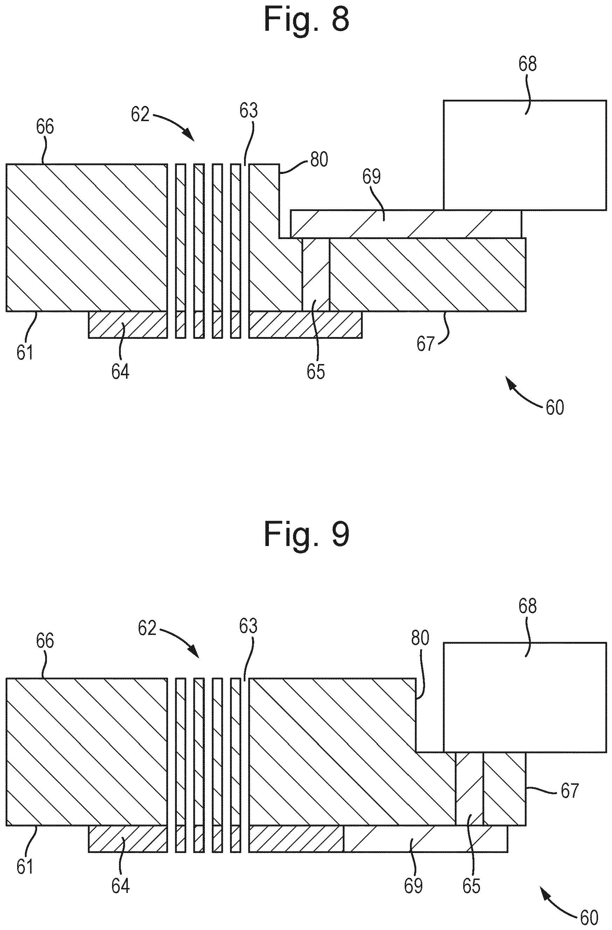

As shown in Figure 7, in an embodiment the electron-optical element 60 comprises an electrical connector 65. The electrical connector 65 is electrically connected to the at least one electronic component 64. As shown in Figure 7, in an embodiment the electrical connector 65 is directly electrically connected to the electronic component 64. The electrical connector 65 may be physically connected to the electronic component 64. However, it is not essential for the electrical connection between the electrical connector 65 and the electronic component 64 to be direct. For example, as will be described in more detail below, the electrical connector 65 may be electrically connected to the electronic component 64 indirectly (see for example Figure 9). An intermediate component may be provided for electrical connection between the electrical connector 65 and the at least one electronic component 64.

As shown in Figure 7, the electrical connector extends through the substrate 61. The electrical connector 65 may be arranged to extend between the two major surfaces of the substrate 61. The electrical connector 65 may electrically connect the upbeam surface of the substrate 61 to the downbeam surface of the substrate 61. In an embodiment the electrical connector is a via. The electrical connector 65 comprises an electrically conductive material. For example, the electrical connector 65 may be a through-silicon via (TSV).

As shown in Figure 7, in an embodiment a substrate 61 comprises a thicker portion 66 and a thinner portion 67. The thinner portion 67 is thinner than the thicker portion 66. The thickness direction for the substrate 61 may be a direction parallel to the at least one beam path. The thickness direction may be parallel to the longitudinal direction of the at least one aperture 63. The thickness direction may be orthogonal to the plane of the substrate 61. The thicker portion 66 is thicker than the thinner portion 67 in a direction parallel to the beam paths. The thinner portion 67 is thinner than the thicker portion 66 in a direction orthogonal to the plane of the substrate 61.

As shown in Figure 7, in an embodiment the electrical connector 65 extends through the thinner portion 67 of the substrate 61. Part of the substrate 61 may be thin, where the electrical connector 65 is provided, while other parts of the substrate 61 may be thicker. An embodiment of the invention is expected to make it easier to provide an electrical connector through a thick electron-optical element 60. It is easier to provide an electrical connector 65 through a thinner substrate. By providing the substrate 61 with a region that is thin locally, the electrical connector 65 may be added more easily, without requiring the whole substrate 61 to be thin.

An embodiment of the invention is expected to make it easier to manufacture an electron-optical element 60 that comprises both apertures 63 and an electrical connector 65 through it. It is easier to form apertures such as the at least one aperture 63 shown in Figure 7 through a thicker substrate. By providing the substrate 61 with both a thicker portion 66 and a thinner portion 67, both the apertures 63 and the electrical connector 65 may be provided through the substrate 61 in a relatively easy manner.

An embodiment of the invention is expected to make it easier to electrically connect major surfaces of an electron-optical element 60 without unduly making it harder to moderate the temperature of the electron-optical element 60. During use of the electron-optical element 60, it may heat up. For example, the electron beams may cause the substrate 61 to heat up for example by interaction between the electron beams and the substrate 61. The electron-optical element 60 may heat up particularly in and around the beam area 62. Additionally, active electronics such as the at least one electronic component 64 may cause the substrate 61 to heat up. A thicker substrate has a greater thermal conductivity, desirably laterally. A thicker substrate is better at transferring heat laterally (i.e. orthogonal to the electron beams) through the substrate 61 desirably towards peripheral edges of the substrate 61. Thus, a thicker substrate makes it easier to remove thermal energy from the sides of the electron-optical element 60 and thus moderate the temperature of the electron-optical element 60. By providing a locally thinner portion 67, the electrical connector 65 may be added and/or made more easily, without unduly decreasing the thermal conductivity of the substrate 61 as a whole by having all of the substrate 61 thin.

As shown in Figure 7, in an embodiment the thicker portion 66 comprises the at least one aperture 63. The aperture 63 may be provided in the thicker portion 66 where it is easier for the apertures 63 to be formed or defined. An embodiment of the invention is expected to make it easier to provide apertures 63 in an electron-optical element 60 that has its major surfaces electrically connected to each other.

As shown in Figure 7, in an embodiment the electrical connector 65 extends substantially parallel to the at least one beam path. The at least one beam path may be substantially orthogonal to the plane of the substrate 61. By providing the electrical connector parallel to the at least one beam path, the electrical connector 65 may be as short as possible while providing electrical connection between the upbeam surface and the downbeam surface of the substrate 61. It is not essential for the electrical connector 65 to be exactly parallel to the at least one beam path. For example, the electrical connector 65 may be arranged to be angled relative to the beam paths. For example, the electrical connector 65 may be positioned diagonally when viewed in a cross-sectional side view. The electrical connector 65 may have a longitudinal direction. The electrical connector 65 may be longer in the thickness direction of the substrate 61 (i.e. the direction parallel to the beam path) than in a lateral direction (i.e. the direction parallel to the plane of the substrate 61). Alternatively, the electrical connector 65 may be wider than it is long. For example, when the thinner portion 67 of the substrate 61 is particularly thin, then the electrical connector 65 may not be required to be very long. The length direction of the electrical connector 65 corresponds to the thickness direction of the substrate 61.

As shown in Figure 7, in an embodiment the component surface provided by the at least one electronic component 64 is a surface of the thicker portion 66 of the substrate 61. Figure 7 shows a transition 80 at which the thickness of the substrate 61 changes between the thicker portion 66 and the thinner portion 67. The transition 80 may correspond to a step change in the thickness of the substrate 61. The transition 80 may form a discontinuity in the thickness of the substrate 61. As shown in Figure 7, the transition 80 may be a sharp transition. Alternatively, the transition may be formed more smoothly. For example, the thickness of the substrate 61 may change gradually from the thickness of the thicker portion 66 to the thickness of the thinner portion 67. In the arrangement shown in Figure 7, the transition 80 is formed by a single step change. The step change may comprise an intermediate angled slope of varying thickness intermediate the thicker portion 66 and the thinner portion 67. In an alternative embodiment, the transition 80 may comprise a plurality of steps, for example of intermediate angled portions or uniformly thick portions, between the thicker portion 66 and the thinner portion 67.

In the view shown in Figure 7, the substrate 61 to the left of the transition 80 corresponds to the thicker portion 66. The substrate 61 to the right of the transition 80 corresponds to the thinner portion 67. As shown in Figure 7, the at least one electronic component 64 may be at least partly to the left of the transition 80, i.e. at least partly part of the thicker portion 66. As shown in Figure 7, in an embodiment part of the component surface provided by the at least one electronic component 64 is a surface of the thinner portion 67. This is shown in Figure 7, where part of the at least one electronic component 64 is to the right of the transition 80, i.e. part of the thinner portion 67. Alternatively, the component surface may be wholly part of the thicker portion 66 (e.g. see Figure 9). A further alternative embodiment, the at least one electronic component 64 may provide the component surface wholly as part of the thinner portion 67. By providing the component surface in the thicker portion 66, the component surface may be provided in and around the beam area 62. The at least one electronic component 64 may operate directly on the electron beams in the beam area 62.

As shown in Figure 7, in an embodiment the at least one electronic component 64 is located adjacent the at least one aperture 63. In an embodiment the component surface surrounds the at least one aperture 63. For example, the component surface may be proximate to the at least one aperture 63. The component surface may adjoin the at least one aperture 63. For example, the component surface may comprise one or more electrodes at each aperture 63.

As shown in Figure 7, in an embodiment the component surface is provided at all of the apertures 63. Alternatively, the component surface may be provided at only a subset of the apertures 63, for example one or more of the apertures 63. As shown in Figure 7, in an embodiment at least one of the apertures 63 is defined in the component surface. The apertures 63 may extend through the component surface provided by the at least one electronic component 64. The at least one electronic component 64 may comprise one or more electrodes that define one or more of the apertures 63. The electrodes may operate on electron beams passing through the apertures 63.

For example, in an embodiment the at least one electronic component 64 comprises one or more deflectors. Each deflector may be configured to operate on an electron beam (or group of electron beams) passing through a respective aperture 63. The deflector may be configured to control a direction of the electron beam downbeam of the electron-optical element 60. For example, the deflector may be configured to control where the electron beam is incident on a downbeam electron-optical element 60 or on the sample location. The deflector may be configured to control whether one or more electron beams passes through apertures of a downbeam planar element or whether the one or more electron beams are blocked by the downbeam planar element.

In an embodiment the at least one electronic component 64 comprises a multipole. A multipole may comprise a plurality of electrodes for a respective aperture 63. The multipole may be configured to correct one or more parameters of the electron beam passing through the aperture 63. For example, in an embodiment the multipole may be a stigmator configured to moderate a shape of an electron beam passing through the aperture 63.

In an embodiment the at least one electronic component 64 comprises one or more detector elements. The detector elements may be configured to detect a current of signal electrons from the sample location.

In an embodiment the at least one electronic component 64 comprises one or more aberration compensators or correctors. The aberration compensators may be formed into an aberration compensator array. In an embodiment the aberration compensator may be configured to operate on an individual aperture 63. For example, the aberration compensator may be configured to control the field curvature and/or astigmatism of the electron beams.

As shown in Figure 7, in an embodiment an electron-optical part comprises the electron-optical element 60 and electronic circuitry (e.g. comprised in a printed circuit board (PCB) 68). As shown in Figure 7, the electronic circuitry is connected to the electrical connector 65. As shown in Figure 7, in an embodiment the electronic circuitry (e.g. the PCB 68) is located such that the electronic circuitry and the at least one electronic component 64 are located on opposite sides of the substrate 61 in a direction parallel to the at least one beam path. In the arrangement shown in Figure 7, the PCB 68 is provided at the upbeam side of the substrate 61. The at least one electronic component 64 is provided at the downbeam side of the substrate 61. However, it is not essential for the PCB 68 to be at the upbeam side. In an alternative embodiment the PCB 68 is provided at the downbeam side of the substrate 61.

As shown in Figure 7, in an embodiment the electronic circuitry is comprised in a PCB 68. The PCB may be secured to the substrate 61. For example, the PCB 68 may be fixed to the substrate 61. In an embodiment the PCB 68 is bonded to the substrate 61. The PCB 68 may be secured to a major surface of the substrate 61. The PCB 68 may overlap a portion of the major surface of the substrate 61. As shown in Figure 7, in an embodiment the PCB 68 extends laterally beyond the peripheral outer edge of the substrate 61.

In an embodiment the electronic circuitry is configured to transfer power to the at least one electronic component 64. For example, the electronic circuitry may be electrically connected to a power supply configured to supply electrical power to the at least one electronic component 64 via the electronic circuitry. Additionally or alternatively, the electronic circuitry may be configured to transfer signals to the at least one electronic component 64. For example, in an embodiment the electronic circuitry is configured to supply control signals to the electronic components 64. The control signals may be, for example, control signals for controlling the gain and/or offset of analog to digital converters (ADCs) comprised in the at least one electronic component 64. In an embodiment the electronic circuitry is configured to transfer signals from the electronic component 64. For example, in an embodiment the electronic circuitry is configured to transfer signals indicative of currents of signal electrons detected at the substrate 61.

As shown in Figure 7, in an embodiment the electrical connector 65 is directly connected to the PCB 68. The electrical connector 65 may be directly connected to the at least one electronic components 64 and the PCB 68.

Figure 8 is a schematic view of an alternative arrangement of an electron-optical element 60. The arrangement shown in and described with reference to Figure 8 may take the features and function of the arrangement as shown in and described with reference to Figure 7 unless stated otherwise. As shown in Figure 8, in an embodiment the electron-optical element 60 comprises an electrically conductive layer 69. The electrically conductive layer 69 may be supported by the substrate 61. In an embodiment the electrically conductive layer 69 comprises a electrically conductive material such as a metal, particularly a metal that has low resistivity (e.g. copper, aluminium or gold). The electrically conductive layer 69 may be a layer formed on a major surface of the substrate 61. For example, as shown in Figure 8, in an embodiment the electrically conductive layer 69 is a layer at the upbeam major surface of the substrate 61. The electrically conductive layer 69 is electrically connected to the electrical connector 65. The connection between the electrically conductive layer 69 and the electrical connector 65 may be direct. The electrically conductive layer 69 may be mechanically connected to the electrical connector 65.

In an embodiment the electrically conductive layer 69 is configured to transfer signals to and from the electrical connector 65. For example, the electrically conductive layer 69 may be configured to transfer power signal and/or communication signals (e.g. control signals) from the electronic circuitry in the PCB 68 to the at least one electronic component 64 via the electrical connector 65. In an embodiment the electrically conductive layer 69 is configured to transfer communication signals (e.g. data signals) from the electronic components 64 via the electrical connector 65 to the electronic circuitry in the PCB 68. The electrically conductive layer 69 may be soldered or wire bonded, for example, to the PCB 68.

In an embodiment the electron-optical element 60 comprises a plurality of electrical connectors 65 extending through the substrate 61. In an embodiment the electrically conductive layer 69 comprises a plurality of traces. The traces may be for respective electrical connectors 65. For example, in an embodiment each of a plurality of electrical connectors 65 is electrically connected to the PCB 68 via a respective trace of the electrically conductive layer 69.

In an embodiment the electrically conductive layer 69 is a coating on the substrate 61. The electrically conductive layer is for electrically connecting the electrical connector 65. The electrically conductive layer 69 may be configured to distribute signals laterally, i.e. parallel to the plane of the substrate 61. The electrically conductive layer 69 may be referred to as a redistribution layer. The electrically conductive layer 69 may be configured to redistribute signals across the substrate 61.

In an embodiment the at least one electronic component 64 comprises multiple layers of electronic circuitry. The layers may be located within the substrate 61 (e.g. as a CMOS device). As shown in Figure 8, an electrical connection for the at least one electronic component 64 is further towards the periphery of the substrate 61 than the at least one electronic component 64. In an embodiment the electrically conductive layer 69 is on the substrate 61 and electrically connected to the electrical connection.

The electrical connection is the external electrical connection with respect to the electrically conductive layer 69. In an embodiment the electrical connection is the electrical connector 65 electrically connected to the at least one electronic component 64 and extending through the substrate 61. Alternatively the electrical connection may be for electrically connecting component on the same side of the substrate 61. In an embodiment the electrically conductive layer 69 extends between the component surface and the electrical connection.

In an embodiment the electrically conductive layer 69 is electrically connected to the electrical connector 65 and the electrical connection (e.g. the PCB 68). As shown in Figure 8, in an embodiment the electrically conductive layer 69 is on a different side of the substrate 61 from the component surface. The electrical connector 65 extends through the substrate 61 between the electrical connection (e.g. the PCB 68) and the at least one electronic component 64.

In an embodiment the electrically conductive layer 69 and/or the at least one electronic component 64 comprises one more electrical elements for processing signals transmitted to and/or from the at least one electronic component, such as a trans impedance amplifier (TIA), a filter and/or an ADC.

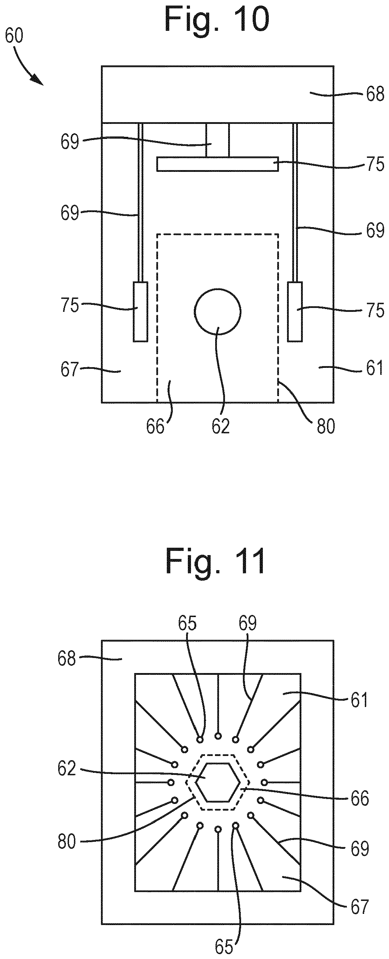

Figure 10 is a schematic plan view of an electron-optical element 60. The electron-optical element 60 may be the electron-optical 60 shown in Figure 8, for example. Figure 10 is a view in a direction parallel to the at least one beam path. The view in Figure 10 is from the upbeam side of the substrate 61.

As shown in Figure 10, in an embodiment the electron-optical element 60 comprises one or more connector regions 75. A connector region 75 is a region in which a plurality of electrical connectors 65 may be located. Electrical connectors 65 may be arranged relatively close to each other within a connector region 75. Figure 10 shows three connector regions 75 positioned around the beam area 62. In an embodiment the number of connector regions 75 is one, two, four or more than four. In the arrangement shown in Figure 10, the connector regions 75 are shown as being substantially longitudinal. Alternatively, the connector regions 75 may be substantially a closed shape such as square, hexagonal or circular, for example, or at least part of two or more sides of such a shape.

As shown in Figure 10, the electrically conductive layer 69 comprises a plurality of traces configured to electrically connect the connector regions 75 to the PCB 68. In an embodiment a plurality of traces of the electrically conductive layer 69 are configured to connect each connector region 75 to the PCB 68. In an embodiment a separate trace may be provided for each electrical connector 65. One or more of the traces may be provided on a surface of the substrate 61 facing the sample.

As shown in Figure 10, in an embodiment the beam area 62 is located between connector regions 75. The connector regions 75 are located in the thinner portion 67 of the substrate 61. The beam area 62 is located in the thicker portion 66 of the substrate 61. The transition 80 between the thinner portion 67 and the thicker portion 66 is located between the beam area 62 and the connector regions 75.

As shown in Figure 10, in an embodiment the thicker portion 66 may have a rectangular shape when viewed in a direction parallel to the at least one beam path. Alternatively, the thicker portion 66 may have a different shape, such as semi-circular, or rectangular with rounded corners. As shown in Figure 10, in an embodiment the thinner portion 67 extends around three sides of the thicker portion 66 when viewed in plan view. Alternatively, the thinner portion 67 may extend along only one side of the thicker portion 66 (e.g. if the two connector regions 75 shown in the bottom half of Figure 10 were omitted), or along only two sides of the thicker portion 66 (e.g. if one of the connector regions 75 shown in the bottom half of Figure 10 was omitted) or along all four sides of the thicker portion 66. In another embodiment, the only portion of the substrate 61 which has a thinner thickness is around respective connector regions 75 and optionally the conductive regions extending over the surface of the substrate, for example when the electrically conductive layer 69 is on the opposite side of the substrate 61 from the at least one electronic component 64 as is described herein. In such an arrangement the PCB 68 may be secured to the substrate 61 at a periphery such as a side of the electron-optical module 55 such as the substrate 61. The thinner portion 67 may be a trench around the connector regions 75 and optionally at least part of the electrically conductive layer 69. An embodiment may have any sized thinner portion 67 between these extremes. However, it is noted that a smaller thinner portion is desirable for optimizing, for example maximizing, the area of the thicker portion 66 for improved structural integrity of the substrate 61. As mentioned above, the electron-optical element 60 shown in Figure 10 may have a structure as shown in Figure 8. For example, the electrically conductive layer 69 may be on the opposite side of the substrate 61 from the at least one electronic component 64. As a result, the at least one electronic component 64 is not shown in Figure 10. In an alternative embodiment the electrically conductive layer 69 may be on the same side of the substrate 61 as the at least one electronic component 64.

As shown in Figure 8, in an embodiment the electrically conductive layer 69 is configured to electrically connect the electrical connector 65 to another component further from the at least one aperture 63. The distance between the apertures 63 and the other component is greater than the distance between the apertures 63 and the electrical connector 65. For example, as shown in Figure 8, in an embodiment the other component that is further from the apertures 63 is the PCB 68. The electrically conductive layer 69 is configured to electrically connect the electrical connector 65 to the PCB 68. Alternatively or additionally, the electrically conductive layer 69 may be configured to electrically connect the electrical connector 65 to other electronic circuitry such as an image data processor and/or a power supply which may be provided on the PCB 68 or electrically connected to the electrically conductive layer 69 via the PCB 68. In an embodiment all electrical connections of the electronic components 64 in or around the beam area 62 may be through the electrically conductive layer 69, the electrical connector 65 and the PCB 68, e.g. even if the one or more external and/or remote components are provided beyond on the PCB 68 (i.e. not on the PCB 68). The electrically conductive layer 69 is configured to electrically connect the electrical connectors 65 which are close to the beam area to one or more components that are much further spaced from a beam area 62.

Figure 9 is a schematic view of another arrangement of an electron-optical element 60. The arrangement shown in and described with reference to Figure 9 may take the features and function of the arrangement as shown in and described with reference to Figure 8 unless stated otherwise. As shown in Figure 9, in an embodiment the electrically conductive layer 69 is located on a side of the substrate 61. For example, in the arrangement shown in Figure 9 the electrically conductive layer 69 is located on the downbeam side (e.g. the major downbeam surface) of the substrate 61. As shown in Figure 9, in an embodiment the at least one electronic component 64 is located on the same side of the substrate 61. Both the electrically conductive layer 69 and the electronic components 64 are located on the same side of the substrate 61.

As shown in Figure 9, in an embodiment the electrically conductive layer 69 is directly connected to the at least one electronic component 64. In an embodiment the electrically conductive layer 69 is located between the electrical connectors 65 and the electronic components 64. The electrical connector 65 may be electrically connected to the at least one electronic components 64 via the electrically conductive layer 69. The electrically conductive layer 69 may comprise a plurality of traces configured to electrically connect respective electrical connectors 65 with the at least one electronic component 64.

The electrically conductive layer 69 may contact a plurality of layers of the at least one electrical component. The electrically conductive layer 69 may be connected directly to a metal layer of the plurality of layers of the at least one electrical component 64. The at least one electronic component 64 may have terminals for electrical connection that are dimensionally smaller than those of a component external to the electron-optical element 60 (e.g. for chip packaging). The electrically conductive layer 69 may serve as an interposer bridging from the component surface dimension to the packaging dimension. The electrically conductive layer 69 may match the pitch density of different chip routing technologies.

As shown in Figures 7-9, in an embodiment the electrical connectors 65 are spaced away from the beam area 62. As shown in Figure 9, in an embodiment the electrical connector 65 is indirectly electrically connected to the at least one electronic component 64. The electrically conductive layer 69 may electrically connect the electrical connector 65 to the at least one electronic component 64. An embodiment of the invention is expected to make it easier to extend the electrical connector 65 through the substrate 61 when manufacturing the electron-optical element 60. By providing the electrically conductive layer 69 intermediate between the electrical connector 65 and the at least one electronic component 64, the electrical connector 65 is not required to electrically connect directly to the at least one electronic component 64. It can be difficult to form the hole into which the electrical connector 65 is to be placed into the required layer (e.g. a lower layer) of the at least one electronic component 64. By providing the electrical connector 65 to be electrically connected to the electrically conductive layer 69, the hole for the electrical connector 65 may be formed more easily through the substrate 61.

An embodiment of the invention is expected to make it easier to moderate the temperature of the electron-optical component 60. As shown in Figure 9, by providing the electrically conductive layer 69 on the same side of the substrate 61 as the at least one electronic component 64, the electrical connector 65 may be located further away from the beam area 62. The transition 80 between the thicker portion 66 and the thinner portion 67 may be located further from the beam area 62. A greater proportion of the substrate 61 may be formed by the thicker portion 66 (compared to in Figure 8, for example). The volume of the substrate 61 may be increased compared to the electron-optical element 60 shown in Figure 8, for example. The average thickness of the substrate 61 may be increased compared to the electron-optical element 60 shown in Figure 8, for example. A generally thicker substrate may have a generally higher lateral thermal conductivity in a lateral direction (i.e. transfer of heat in a direction substantially parallel to a plane of the substrate 61). A thicker substrate 61 generally has a greater cross-sectional area for the thermal path in a lateral direction. This may help to transfer heat away from the beam area 62 and the at least one electronic component 64 more efficiently for example towards the periphery of the substrate 61. This may help to remove thermal energy from the sides of the electron-optical module 55. This may help to moderate the temperature of the electron-optical component 60.

An embodiment of the invention is expected to make it easier to provide electrical connections for electronic components located where space is constrained. By providing the electrical connector 65 connecting two sides of the substrate 61, the electronic components 64 can be electrically connected at the opposite side of the electron-optical element 60 where there may be more space. For example, in an embodiment the electron-optical element 60 may be the most downbeam electron-optical element of an electron-optical device 40. There may be only a small gap downbeam of the electron-optical component 60 to the sample 208. Alternatively, there may be only a small gap downbeam of the electron-optical element 60 to the next component of the electron-optical device 40. The electrical connector 65 brings the electrical contact to the more accessible other side of the substrate 61. The other side of the substrate 61 may be laterally accessible by electrical connections, such as via the PCB 68 from outside of the electron-optical module 55, such as to a side of the electron-optical module 55 at or adjoining a spacer 70. In the arrangement shown in Figure 8, for example, the electrically conductive layer 69 is at the more accessible side of the substrate 61. The electrically conductive layer 69 does not take up any space on the other side of the substrate 61, for example the surface of a substrate 61 which may face a sample, where space may be more constrained.

An embodiment of the invention is expected to reduce the possibility of electrical interference with an electron beam. The electrically conductive layer 69 allows a spacer 70 to be connected to the substrate 61 further radially outward (compared to in Figure 7, for example) while avoiding conflict with the PCB 68. By allowing the spacer 70 to be further from the beam area 62, the possibility of electrical interference with the at least one electron beam is reduced.

As shown in Figure 9, in an embodiment the electrically conductive layer 69 is at least partly on the thicker portion 66 and at least partly on the thinner portion 67 of the substrate 61. When viewed in plan view, the electrically conductive layer 69 may cross the transitions 80 between the thicker portion 66 and the thinner portion 67.

As shown in Figures 7-10, in an embodiment the thinner portion 67 of the substrate 61 extends to a peripheral edge of the substrate 61. The PCB 68 may be secured to a major surface of the thinner portion 67 and extend beyond the peripheral edge of the substrate 61. In an embodiment the thinner portion 67 extends towards the at least one aperture 63. In an embodiment the thinner portion 67 extends towards the at least one electronic component 64. The transition 80 between the thinner portion 67 and the thicker portion 66 may be spaced from the beam area 62. As shown in Figure 9, in an embodiment the transition 80 is spaced from the at least one electronic component 64. Alternatively, as shown in Figure 8, in an embodiment the at least one electronic component 64 extends across the transition 80 when viewed in a direction parallel to the at least one beam path. In an embodiment the thinner portion 67 extends so as to overlap with the component surface when the electrically conductive layer 69 is on a different side of the substrate 61 from the at least one electronic component 64. As shown in Figure 8, in an embodiment the component surface formed by the at least one electronic component 64 is configured to overlap the electrically conductive layer 69 when the component surface and the electrically conductive layer 69 are on different sides of the substrate 61. As shown in Figure 9, in an embodiment the thinner portion 67 extends so as to be spaced apart from the component surface. The thinner portion 67 and the component surface do not overlap. The electrically conductive layer 69 may be on the same side as the component surface. In an embodiment at least part of the electrically conductive layer 69 is on the component surface provided by the at least one electronic component 64. Traces of the electrically conductive layer 69 may be connected to terminals (e.g. electrodes or contacts or contact points) of the at least one electronic component 64.

In an embodiment the at least one electronic component 64 is integrated into the substrate 61. Alternatively, the at least one electronic component 64 may be secured to the substrate 61. In an embodiment the substrate 61 comprises the at least one electronic component 64. For example, in an embodiment the at least one electronic component 64 comprises a plurality of layers. The layers may be layers of circuitry. For example, in an embodiment the at least one electronic component 64 comprises CMOS circuitry.

In an embodiment the CMOS circuitry comprises a metal layer or multiple metal layers. The metal layer may comprise one or more electrodes for example which may provide a surface of the CMOS circuitry on the substrate 61 which in operation may face a sample. For example, the metal layer may comprise detector elements configured to detect signal electrons. The detector elements may be referred to as capture electrodes. Capture electrodes are examples of sensor units for detecting signal electrons. Power and control signals of the CMOS may be connected to the CMOS by the electrical connectors 65. The CMOS circuitry may comprise a logic layer for example in one more different layers from the one or more electrodes. The logic layer may include amplifiers such as TIAs, ADCs and/or read out logic.

Figure 11 schematically depicts an alternative arrangement for an electron-optical element 60. The view shown in Figure 11 is a view along a direction parallel to the at least one beam path. As shown in Figure 10, in an embodiment the beam area 62 forms a circular shape when viewed in plan view. The circular shape is formed of the apertures 63 for example as an aperture array in the surface of the beam area 62. As shown in Figure 11, in an alternative embodiment the beam area 62 is hexagonal when viewed in plan view. Alternatively, the beam area 62 may be square or rectangular, for example or any other desirable closed shape, which is desirably regular e.g. a shape having similar sized sides.

As shown in Figure 11, it is not essential for the thinner portion 67 to extend to a peripheral edge of the substrate 61. In an embodiment the PCB 68 surrounds the beam area 62 in plan view. The PCB 68 may be provided with a central hole. The beam area 62 may be located within the central hole of the PCB 68 when viewed in plan view. The electrical connectors 65 may be located within the central hole of the PCB 68 when viewed in a direction orthogonal to the plane of the substrate 61. As shown in Figure 11, in an embodiment the electrical connectors 65 are arranged to surround the beam area 62. The electrically conductive layer 69 may provide short connections between the electronic circuitry of the PCB 68 and the electrical connectors 65. The electron-optical element 60 shown in Figure 11 may have a structure as shown in Figure 8. For example, the electrically conductive layer 69 may be on the opposite side of the substrate 61 from the at least one electronic component 64. As a result, the at least one electronic component 64 is not shown in Figure 11. In an alternative embodiment the electrically conductive layer 69 may be on the same side of the substrate 61 as the at least one electronic component 64.

The invention may be embodied as a method for providing an electrical connection through a substrate 61 of an electron-optical element 60. In an embodiment the method comprises extending an electrical connector 65 through a portion of a substrate 61.

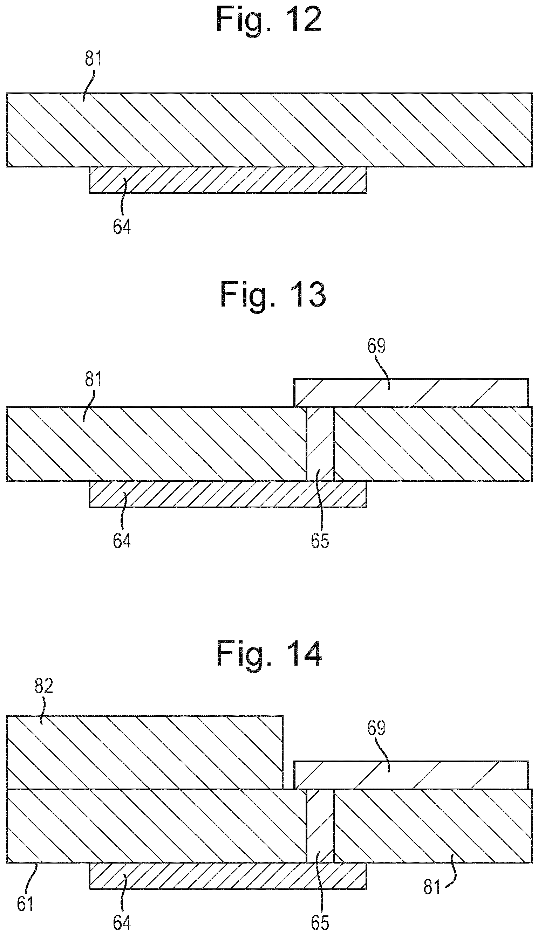

Figures 12-15 schematically illustrate different steps of a method of making an electron-optical element 60. As shown in Figure 12, in an embodiment the method comprises providing a portion of a substrate. For example, a substrate portion 81 is provided. The substrate portion 81 has a component surface provided by at least one electronic component 64. The substrate portion 81 forms part of the substrate 61 of the electron-optical element 60 once the electron-optical element 60 has been made. The substrate portion 81 may be a substrate. The substrate portion 81 may be planar. In an embodiment the substrate portion 81 is the same size and shape as the substrate 61 of the completed electron-optical element 60 when viewed in plan view. The substrate portion 81 has a thickness equal to the thickness of the thinner portion 67 of the substrate 61. The substrate portion 81 forms the thinner portion 67.

As shown in Figure 13, in an embodiment the method comprises extending an electrical connector 65 through the substrate portion 81, such that the electrical connector 65 is electrically connected to the at least one electronic component 64. In an embodiment a hole is formed through the substrate portion 81. The hole may extend to the bottom layer of the at least one electronic component 64. The electrical connector 65 may be inserted into the hole(or through opening or through hole) through the substrate portion 81, for example material may be deposited in the hole to fill the hole and form the electrical connector 65. The electrical connector 65 may be a via or a metallic connector. The electrical connector 65 may consist of an electrically conductive material, such as a metal, particularly a metal that has low resistivity (e.g. copper, aluminium or gold).

As shown in Figure 13, in an embodiment the method comprises applying an electrically conductive layer 69. The electrically conductive layer 69 is for connecting to the electrical connector 65. In an embodiment the electrically conductive layer 69 is applied after extending the electrical connector 65 through the substrate portion 81.

In an embodiment the electrically conductive layer 69 is for electrically connecting to the at least one electronic component 64. In an embodiment the electrically conductive layer 69 is configured to extend between an electronic circuit board (e.g. a PCB 68) on a different side of the substrate 61 from the component surface.

In an embodiment the extending of the electrical connector 65 comprises etching a through hole through the substrate portion 81, for example before the electrically conductive layer 69 is formed. The through hole is filled with conductive material such as a metal. Alternatively, in an embodiment the electrically conductive layer 69 is applied before the electrical connector 65 is connected through the substrate portion 81.

As shown in Figure 14, in an embodiment the method comprises securing two substrate portions 81, 82 together so as to form the substrate 61. The combined thickness of the substrate portions 81, 82 may be equal to the thickness of the thicker portion 66 of the substrate 61. The added substrate portion 82 may have a size and shape equal to the size and shape of the thicker portion 66 of the substrate 61 when viewed in plan view. As shown in Figure 14, in an embodiment at least one peripheral edge of the two substrate portions 81, 82 are aligned in a direction orthogonal to the plan of the substrate 61. In an embodiment the two substrate portions 81, 82 are secured together by a substrate bonding process. In an embodiment the two substrate portions 81, 82 are secured together by overlapping the two substrate portions 81, 82 for the thicker portion 66 of the substrate 61. In an embodiment the thinner portion 67 is formed from one of the two substrate portion. Part of the substrate portion 81 that does not overlap with the other substrate portion 82 forms the thinner portion 67 of the substrate 61.

In an embodiment the securing of the two substrate portions 81, 82 together is after the electrical connector 65 is extended through the substrate portion 81. An embodiment of the invention is expected to make it easier to make the electron-optical element 60. It can be easier to perform processes on a substrate that has a substantially uniform thickness. By adding the electrical connector 65 before bonding the two substrate portions 81, 82 together, the process of applying the electrical connector 65 may be performed on a substrate that has substantially uniform thickness. This can simplify the process. In an embodiment the electrically conductive layer 69 is applied before the substrate portions 81, 82 are bonded together. It can be easier to apply the electrically conductive coating 69 to a substrate of substantially uniform thickness.

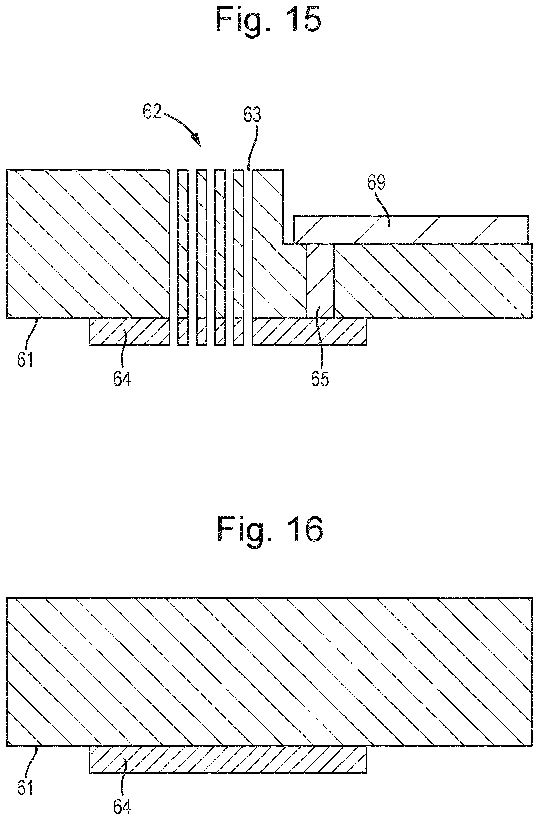

As shown in Figure 15, in an embodiment the method comprises defining at least one aperture 63 through the substrate 61. The aperture 63 is for the passage there through of at least one beam path. As shown in Figure 15, in an embodiment a plurality of apertures 63 are formed in a beam area 62. The apertures 63 may be formed through thicker portion 66 of the substrate 61. The apertures 63 may be formed through both of the substrate portions 81, 82 so as to extend all the way through the thickness of the substrate 61.

In an embodiment the electrical connector 65 is extended through the substrate 61 before the at least one aperture 63 is defined through the thicker portion 66 of the substrate 61.

In an embodiment a method of making an electron-optical part comprises securing a PCB 68 to the substrate 61. The PCB 68 may be electrically connected to the electrically conductive layer 69. An electron-optical part such as shown in Figure 8 may be formed.

A method of making an electron-optical element 60 has been described with reference to Figures 12-15. The electron-optical element 60 that is made may have an arrangement as shown in Figure 8, for example.

In an alternative embodiment, the electron-optical element 60 that is made may have an arrangement as shown in Figure 9, for example. The method making such an electron-optical element 60 may be as described with reference to Figures 12-15, with the following difference. The electrically conductive layer 69 may be formed on the same side of the substrate portion 81 as the component surface provided by the at least one electronic component 64.

It is not essential for the electrical connector 65 and the electrically conductive layer 69 to be provided before the substrate portions 81, 82 are bonded together as shown in and described with respect to Figures 12-15. In an alternative embodiment, the substrate portions 81, 82 may be secured together before the electrical connector 65 is extended through the thinner portion 67. Additionally or alternatively, the substrate portions 82, 81 may be secured together before the electrically conductive layer 69 is applied.

In an embodiment an electron-optical element 60 as shown in Figure 7 may be made. The method for making such an electron-optical element 60 may be as described with reference to Figures 12-15, with the following difference. The electrically conductive layer 69 may be omitted.

Another method for providing an electrical connection through a substrate 61 of an electron-optical element 60 is described with reference to Figures 15-18. As shown in Figure 16, in an embodiment the method comprises providing a substrate 61. The substrate 61 has a component surface provided by at least one electronic component 64. In an embodiment the method comprises forming the component surface by forming the electronic component 64. The substrate 61 that is provided may have the same thickness as the desired thickness for the substrate 61 in the electron-optical element 60 that is to be made.

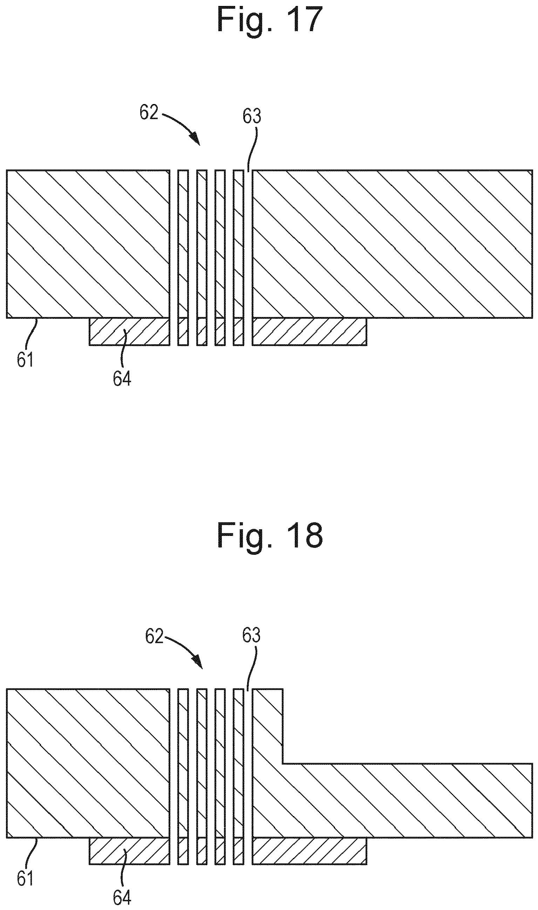

As shown in Figure 17, in an embodiment the method comprises defining at least one aperture 63 through the substrate 61. The aperture 63 is for the passage there through of the at least one beam path. The apertures 63 extend all the way through the thickness of the substrate 61.

As shown in Figure 18, in an embodiment the method comprises removing material from the substrate body so as to form the thinner portion 67 of the substrate 61. For example, in an embodiment the material is removed by etching. For example a dry etching process may be used. Alternatively a wet etching process may be used. Alternatively, the material may be removed by grinding or cutting, for example.

In an embodiment the apertures 63 are defined before the material is removed from the substrate body. It can be easier to define the apertures 63 through the substrate 61 when the substrate has a substantially uniform thickness. An embodiment of the invention is expected to make it easier to make the electron-optical element 60.

In an embodiment the method comprises extending an electrical connector 65 through a portion of the substrate 61. For example, an electrical connector 65 may be extended through the thinner portion 67 of the substrate 61 shown in Figure 18 so as to provide an electron-optical element 60 as shown in Figure 15. As shown in Figure 15, in an embodiment the method comprises applying an electrically conductive layer 69.

In an embodiment the material is removed from the substrate body before extending the electrical connector 65 through the thinner portion 67 of the substrate. This is easier to form the electrical connector 65 through a thinner portion of the substrate after removing material from the substrate body. In an embodiment the removal of the material is after the at least one aperture 63 has been defined through the thicker portion 66 of the substrate 61.

In an embodiment the apertures 63 are protected while the material is removed from the substrate body so as to form the thinner portion 67 of the substrate 61. For example, a protective cover or a protective material may be provided to act as a barrier to protect the apertures 63.

The electron-optical element 60 that is made may have a structure as shown in Figure 8, for example. In an alternative embodiment an electron-optical element 60 as shown in Figure 9 may be made. The method for making the electron-optical element 60 shown in Figure 9 may be the same as the method described in relation to Figures 15-18, with the following difference. The electrically conductive layer 69 may be applied to the same side of the substrate 61 as the at least one electronic component 64. The electrically conductive layer 69 may be for electrically connecting to the at least one electronic component 64. In an embodiment the electrically conductive layer 69 extends between the electrical connector 65 and the at least one electronic component 64 (or the component surface provided by the at least one electronic component 64).

In an alternative embodiment an electron-optical element 60 having a structure as shown in Figure 7 may be made. The method for making such an electron-optical element 60 may be as described above in relation to Figures 15-18, with the following difference. The electrically conductive layer 69 may be omitted.

In an embodiment the at least one aperture 63 is formed by etching the at least one aperture 63 through the substrate 61. In an embodiment the at least one aperture 63 is formed through the thicker portion 66 of the substrate 61. In an embodiment the at least one aperture 63 is formed using deep reactive ion etching, for example a Bosch process.

The electron-optical module 55 may comprise or be a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

In an embodiment at least one of the electron-optical elements 60 comprises a micro-electro mechanical component. In an embodiment the electron-optical module 55 comprises one or more electron-optical elements which comprise an element which may be referred to as a microelectromechanical component (despite such component may not comprise a moving or moveable feature) or may be made using techniques suited to make microelectromechanical components (for example a 'MEMS technique') some of which are designed to have electron-optical functionality. The electron-optical module 55, or at least components of the electron-optical module 55, may be manufactured by such techniques. The electron-optical module 55 may comprise one or more elements which may be considered MEMS elements. One or more of such elements may be controlled to be set at a high potential difference relative to a reference potential (e.g. ground) during use. Such elements may be electrically connected to one or more voltage supplies for supplying the voltages to the elements. In an embodiment a controller is configured to control the voltage applied to the elements. Such elements may require accurate positioning (for example alignment) within the electron-optical module 55 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack of such an electron-optical module 55 such as during operation for example without distortion of the electron-optical module 55 for example by externally applied force or moment. An embodiment of the invention may in addition or alternatively enable more accurate positioning, for example alignment, of such elements with respect to other elements in the electron-optical device 40 and thus of the stack of the electron-optical module 55 comprising such elements within the electron-optical device 40.

As mentioned above, in an embodiment the electron-optical module 55 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the electron-optical module 55 comprises a collimator. For example, in an embodiment the electron-optical module 55 comprises a magnetic collimator in combination with an electro static condenser lens arrays. The electron-optical module 55 may comprise a single aperture lens array with one or two macro electrodes, placed away from the virtual source conjugate plane.

In an alternative embodiment, the electron-optical module 55 comprises a magnetic macro lens in combination with an electrostatic slit deflector. The magnetic macro lens may be for collimating. As a further alternative, in an embodiment the electron-optical module 55 comprises a combined magnetic and electrostatic macro lens and a downbeam slit deflector.

In general, the electron-optical module 55 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focussed primarily on multi-beam electron-optical devices 40. The invention is equally applicable to single-beam electron-optical devices 40.

A plurality of electron-optical devices may be comprised in an electron-optical device array. The electron-optical devices of the electron-optical device array are preferably be configured to focus respective multi-beams simultaneously onto different regions of the same sample.

While the present invention has been described in connection with various embodiments, other embodiments of the invention will be apparent to those skilled in the art from consideration of the specification and practice of the invention disclosed herein. For example, as described above in an embodiment the substrate has portions of different thicknesses, with the electrical connector extending through the thinner portion. However, the thickness of the substrate may alternatively be uniform. The electrical connection for the electronic component may be further towards the periphery of the substrate than the electronic component and the electrically conductive layer may be electrically connected to the electrical connection. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses.
Clause 1. A charged particle-optical element for a charged particle-optical module configured to direct charged particles along at least one beam path, the charged particle-optical element comprising:
   a substrate comprising at least one aperture for passage therethrough of the at least one beam path;
   at least one electronic component so as to provide a component surface of the substrate; and
   an electrical connector electrically connected to the at least one electronic component and extending through the substrate;
   wherein the substrate comprises a thicker portion and a thinner portion that is thinner than the thicker portion, and the electrical connector extends through the thinner portion.
Clause 2. The charged particle-optical element of clause 1, wherein the thicker portion comprises the at least one aperture.
Clause 3. The charged particle-optical element of clause 1 or 2, wherein the electrical connector extends substantially parallel to the at least one beam path.
Clause 4. The charged particle-optical element of any preceding clause, wherein the component surface is a surface of the thicker portion of the substrate in a direction parallel to the at least one beam path.
Clause 5. The charged particle-optical element of any preceding clause, wherein the at least one electronic component is located adjacent the at least one aperture, desirably the component surface surrounds the at least one aperture.
Clause 6. The charged particle-optical element of any preceding clause, comprising an electrically conductive layer supported by the substrate and connected to the electrical connector, desirably the electrically conductive layer is a coating on the substrate electrically connecting the electrical connector.
Clause 7. The charged particle-optical element of clause 6, wherein the electrically conductive layer is located such that the electrically conductive layer and the at least one electronic component are located on opposite sides of the substrate in a direction parallel to the at least one beam path.
Clause 8. The charged particle-optical element of clause 6 or 7, wherein the electrically conductive layer is configured to electrically connect the electrical connector to another component further from the at least one aperture.
Clause 9. The charged particle-optical element of clause 6, wherein the electrically conductive layer is located on a side of substrate and the at least one electronic component is located on the same side of the substrate in a direction parallel to the at least one beam path.
Clause 10. The charged particle-optical element of clause 6 or 9, wherein the electrically conductive layer is configured to electrically connect the electrical connector to the at least one electronic component.
Clause 11. The charged particle-optical element of any of clauses 6-10, wherein the electrically conductive layer is at least partly on the thicker portion and at least partly on the thinner portion in a direction parallel to the at least one beam path.
Clause 12. The charged particle-optical element of any preceding clause, wherein the thinner portion of the substrate extends to a peripheral edge of the substrate, desirably the thinner portion extends towards the at least one aperture and/or the at least one electronic component.
Clause 13. The charged particle-optical element of clause 12, wherein the thinner portion extends so as to overlap with component surface when the electrically conductive layer is on a different side of the substrate from the at least one electronic component.
Clause 14. The charged particle-optical element of clause 12 or 13, wherein the component surface configured to overlap the electrically conductive layer when the electrically conductive layer is on a different side of the substrate from the at least one electronic component.
Clause 15. The charged particle-optical element of any preceding clause, wherein the at least one electronic component comprises one or more detector elements configured to detect signal charged particles, desirably an individual electronic component is a detector element.
Clause 16. The charged particle-optical element of any preceding clause, wherein the at least one electronic component comprises one or more deflectors and/or one or more correctors configured to operate on at least one beam path desirably an individual electronic component is a deflector and/or corrector, for example comprising a plurality of electrodes around an individual aperture of the at least one aperture.
Clause 17. The charged particle-optical element of any preceding clause, wherein the at least one electronic component is integrated into the substrate alternatively the at least one electronic component is secured to the substrate, desirably the substrate comprises the at least one electronic component. Clause 18. The charged particle-optical element of any preceding clause, wherein the electrical connector is a via.
Clause 19. The charged particle-optical element of any preceding clause, wherein the at least one electronic component comprises a plurality of layers, desirably a plurality of layers of circuitry, for example the at least one electronic component comprises CMOS circuity.
Clause 20. The charged particle-optical element of any preceding clause, comprising a microelectromechanical component.
Clause 21. A charged particle-optical part comprising:
   the charged particle-optical element of any preceding clause; and
   electronic circuitry electrically connected to the electrical connector and located such that the electronic circuitry and the at least one electronic component are located on opposite sides of the substrate in a direction parallel to the at least one beam path.
Clause 22. The charged particle-optical part of clause 19, wherein the electronic circuitry is comprised in a printed circuit board secured to the substrate.
Clause 23. The charged particle-optical part of clause 20, wherein the printed circuit board extends beyond a peripheral edge of the substrate.
Clause 24. A charged particle-optical module configured to direct charged particles along at least one beam path towards a sample location, the charged particle-optical module comprising the charged particle-optical element of any of clauses 1-18 or the charged particle-optical part of any of clauses 19-21.
Clause 25. The charged particle-optical module of clause 22 comprising at least one of: a deflector array comprising individual deflectors configured to controllably operate on the beam paths; a beam stop array comprising an array of apertures for passage of beam paths; an objective lens array configured to focus the charged particles onto the sample location; and a condenser lens array configured to generate a plurality of charged particle beams from a source beam and/or focus the plurality of beams at an intermediate focus plane.
Clause 26. A charged particle-optical device for directing charged particles onto a sample location, the charged particle-optical device comprising the charged particle-optical module of clause 23.
Clause 27. A charged particle-optical apparatus comprising the charged particle-optical module of clause 23 or the charged particle-optical device of clause 24.
Clause 28. The charged particle-optical apparatus of clause 25, further comprising an actuatable stage for supporting a sample at the sample location.
Clause 29. A method for providing an electrical connection though a substrate of a charged particle-optical element for a charged particle-optical module configured to direct charged particles along at least one beam path extending through at least one aperture through the substrate for passage therethrough of the at least one beam path, the method comprising:
   extending an electrical connector through a portion of a substrate that has a component surface provided by at least one electronic component, such that the electrical connector is electrically connected to the at least one electronic component;
   wherein the substrate comprises at least one aperture for passage therethrough of the at least one beam path, the substrate comprises a thicker portion and a thinner portion that is thinner than the thicker portion in a direction parallel to the at least one beam path, and the electrical connector extends through the thinner portion.
Clause 30. A method for providing an electrical connection though a substrate of a charged particle-optical element for a charged particle-optical module configured to direct charged particles along at least one beam path extending through at one aperture through the substrate for passage therethrough of the at least one beam path, the method comprising:
   extending an electrical connector through a portion of a substrate that has a component surface provided by at least one electronic component, such that the electrical connector is electrically connected to the at least one electronic component; and
   defining at least one aperture through the substrate for passage therethrough of the at least one beam path,
   wherein the substrate comprises a thicker portion and a thinner portion that is thinner than the thicker portion in a direction parallel to the at least one beam path, and the electrical connector extends through the thinner portion.
Clause 31. The method of clause 29 or 30, comprising securing two substrate portions together so as to form the substrate.
Clause 32. The method of clause 31, wherein the securing comprising overlapping the two substrate portions for the thicker portion, desirably forming the thinner portion from one of the two substrate portions.
Clause 33. The method of clause 31 or 32, wherein the securing is after the extending the electrical connector through one of the two substrate portions, and/or before the defining of the of the at least one aperture through the thicker portion.
Clause 34. The method of clause 29 or 30, comprising removing material from a substrate body so as to form the thinner portion of the substrate.
Clause 35. The method of clause 34, wherein the removing is before the extending the electrical connector through the thinner portion of the substrate and/or after the defining of the at least one aperture through the thicker portion.
Clause 36. The method of any of clauses 29 to 35, wherein an electrically conductive layer is applied after the extending of the electrical connector, the electrically conductive layer for connecting to the electrical connector.
Clause 37. The method of any of clauses 29 to 36, wherein the extending of the electrical connector comprising etching a through hole through the portion of the substrate and filling the through hole with conductive material.
Clause 38. The method of any of clauses 29 to 37, wherein the at least one aperture is formed by etching the at least one aperture through the substrate, desirably through the thicker portion.
Clause 39. A charged particle-optical element for a charged particle-optical module configured to direct charged particles along at least one beam path, the charged particle-optical element comprising:
   a substrate comprising at least one aperture for passage therethrough of the at least one beam path;
   at least one electronic component configured to provide a component surface of the substrate and comprising multiple layers of electronic circuitry (desirably within the substrate), the at least one aperture defined in the component surface;
   an electrical connection for the at least one electronic component further towards the periphery of the substrate than the at least one electronic component; and
   an electrically conductive layer on the substrate and electrically connected to the electrical connection.
Clause 40. The charged particle-optical element of clause 39, wherein desirably the electrically conductive layer is a coating on the substrate electrically connecting the electrical connector.
Clause 41. The charged particle-optical element of clause 39 or 40, wherein the electrical connection is an electrical connector [or via] electrically connected to the at least one electronic component and extending through the substrate, desirably the electrically conductive layer extending between the component surface and the electrical connection, desirably the electrically conductive layer contacting a plurality of layers of the at least one electrical component.
Clause 42. The charged particle-optical element of clause 39 or 40, wherein an electrical connector extends through the substrate, desirably the electrically conductive layer is electrically connected to the electrical connector and the electrical connection, desirably the electrically conductive layer is on a different side of the substrate from the component surface, desirably the electrical connector extends through the substrate between the electrical connection and the at least one electronic component. Clause 43. The charged particle-optical element of clause 41 or 42, wherein the substrate has a thinner portion and a thicker portion (that js a larger dimension in the direction of the beam path), the electrical connector extending through the thinner portion and the at least one aperture extending through the ticker portion.
Clause 44. The charged particle-optical element of clause 41 or 42, wherein the electrical connector is configured to transmit power and or control signals to the at least one component and/or data signals from the at least one component.
Clause 45. The charged particle-optical element of any of clauses 39-43, wherein the electrically conductive layer is configured to transmit power and control data to the at least one electronic component and/or data signals from the at least one component.
Clause 46. The charged particle-optical element of any of clauses 39-44, wherein the electrically conductive layer and/or at least one component comprise one more electrical elements for processing signals transmitted to and/or from the at least one electronic component, such as trans impedance amplifier, a filter and/ or an analogue to digital converter.

## Claims

1. A charged particle-optical element for a charged particle-optical module configured to direct charged particles along at least one beam path, the charged particle-optical element comprising:
a substrate comprising at least one aperture for passage therethrough of the at least one beam path;
at least one electronic component so as to provide a component surface of the substrate; and
an electrical connector electrically connected to the at least one electronic component and extending through the substrate;
wherein the substrate comprises a thicker portion and a thinner portion that is thinner than the thicker portion, and the electrical connector extends through the thinner portion.

2. The charged particle-optical element of claim 1, wherein the thicker portion comprises the at least one aperture.

3. The charged particle-optical element of claim 1 or 2, wherein the electrical connector extends substantially parallel to the at least one beam path.

4. The charged particle-optical element of any preceding claim, wherein the component surface is a surface of the thicker portion of the substrate in a direction parallel to the at least one beam path.

5. The charged particle-optical element of any preceding claim, wherein the at least one electronic component is located adjacent the at least one aperture, desirably the component surface surrounds the at least one aperture.

6. The charged particle-optical element of any preceding claim, comprising an electrically conductive layer supported by the substrate and connected to the electrical connector, desirably the electrically conductive layer is a coating on the substrate electrically connecting the electrical connector.

7. The charged particle-optical element of claim 6, wherein the electrically conductive layer is located such that the electrically conductive layer and the at least one electronic component are located on opposite sides of the substrate in a direction parallel to the at least one beam path.

8. The charged particle-optical element of claim 6 or 7, wherein the electrically conductive layer is configured to electrically connect the electrical connector to another component further from the at least one aperture.

9. The charged particle-optical element of any of claims 6-8, wherein the electrically conductive layer is at least partly on the thicker portion and at least partly on the thinner portion in a direction parallel to the at least one beam path.

10. The charged particle-optical element of any preceding claim, wherein the thinner portion of the substrate extends to a peripheral edge of the substrate, desirably the thinner portion extends towards the at least one aperture and/or the at least one electronic component.

11. The charged particle-optical element of claim 10, wherein the thinner portion extends so as to overlap with component surface when the electrically conductive layer is on a different side of the substrate from the at least one electronic component; and/or wherein the component surface configured to overlap the electrically conductive layer when the electrically conductive layer is on a different side of the substrate from the at least one electronic component.

12. The charged particle-optical element of any preceding claim, wherein the at least one electronic component comprises one or more detector elements configured to detect signal charged particles, desirably an individual electronic component is a detector element.

13. The charged particle-optical element of any preceding claim, wherein the at least one electronic component is integrated into the substrate alternatively the at least one electronic component is secured to the substrate, desirably the substrate comprises the at least one electronic component.

14. The charged particle-optical element of any preceding claim, wherein the electrical connector is a via.

15. A charged particle-optical part comprising:
the charged particle-optical element of any preceding claim; and
electronic circuitry electrically connected to the electrical connector and located such that the electronic circuitry and the at least one electronic component are located on opposite sides of the substrate in a direction parallel to the at least one beam path.
